Europäisches Patentamt

European Patent Office

Office européen des brevets

(19)

(11) Publication number: **0 507 470 A2**

# EUROPEAN PATENT APPLICATION

(12)

(21) Application number: **92302354.3**

(22) Date of filing: **19.03.92**

(51) Int. Cl.⁵: **G01R 13/34**

(30) Priority: **01.04.91 US 677907**

(43) Date of publication of application:
**07.10.92 Bulletin 92/41**

(84) Designated Contracting States:
**DE FR GB NL**

(71) Applicant: **TEKTRONIX INC.**
**Howard Vollum Park 14150 S.W. Karl Braun**
**Drive P.O.Box 500, Mail Stop 50-PAT**
**Beaverton Oregon 97077-0001(US)**

(72) Inventor: **Balakrishnan, Shiv K.**
**16160 S.W. Granite Court**
**Beaverton, Oregon 97077(US)**
Inventor: **Azinger Frederick A,II.**
**6880 S.W. 160th Avenue**
**Beaverton, Oregon(US)**
Inventor: **Averill, Edward E.**
**8815 S.W. Oxbow Terrace**
**Beaverton, Oregon 97005(US)**
Inventor: **Etheridge, Eric P.**
**P.O. Box 2038**
**Beaverton, Oregon 97075(US)**

(74) Representative: **Wombwell, Francis et al**
**Potts, Kerr & Co. 15, Hamilton Square**
**Birkenhead Merseyside L41 6BR(GB)**

(54) **Digital oscilloscope with real-time digital signal processor.**

(57) A real-time digital signal processor (32) is capable of providing increased vertical resolution of digital input signals, including single-shot input signals. In a preferred embodiment, the digital signal processor is employed in a digital oscilloscope (10) having an analog-to-digital converter (30) that generates and delivers to the signal processor successive digital input words representing an input electrical signal during a sampling period. The signal processor selectively averages successive ones of the digital input words and delivers an averaged digital word to a waveform memory circuit (34). The process of averaging increases the vertical resolution by accumulating a sum of the digital input words. The sum contains more digits than the original digital input words. The sum is then divided by shifting to generate the averaged digital word in which the extra accumulated digits become a fractional remainder that provides the additional resolution.

FIG.1

Technical Field

The present invention relates to digital signal processing and, in particular, to a real-time digital signal processor that provides increased digital resolution of sampled input signals.

Background of the Invention

A conventional digital oscilloscope includes data acquisition circuitry that acquires input samples of an input electrical signal during spaced time intervals. The input signal may be analog or digital, and each input sample represents the voltage magnitude of the input signal during the time interval. An analog-to-digital converter receives the input samples and generates for each of them a digital input word of a value corresponding to the input sample voltage magnitude. The digital words, referred to as quantized samples, are stored in a waveform memory until they are retrieved to reconstruct a waveform depicting the input signal over a sampling period.

The accuracy with which the reconstructed waveform depicts the input electrical signal is limited by the number of bits in (i.e., the vertical resolution of) each quantized sample and the sampling frequency at which the quantized samples can be generated and stored. The analog-to-digital converter is typically capable of generating the quantized samples at a frequency greater than a data transfer frequency at which the waveform memory is capable of receiving the quantized samples. As a consequence, the sampling frequency is typically fixed at the data transfer frequency of the waveform memory.

A conventional data transfer frequency is 250 MHz. However, some digital oscilloscopes employ four multiplexed data acquisition circuits that are each capable of operating at a sampling frequency of 250 MHz. Such digital oscilloscopes are, therefore, capable of operating at an overall sampling frequency of about 1 Giga-Hertz.

Digital oscilloscopes typically employ digital signal processing methods for improving the accuracy with which the quantized samples represent the input electrical signal. One such method that is described in U.S. Pat. No. 4,495,586 of Andrews utilizes a technique called random equivalent time sampling. Random equivalent time sampling entails repeatedly sampling a periodic input signal at different time intervals.

For example, a first set of input samples is acquired during a first sampling period at a first series of equally spaced time intervals. A second set of input samples is acquired during an identical second sampling period at a second series of equally spaced time intervals. However, the first and second series of time intervals are offset from each other. As a result, the first and second sets of input samples represent different times during the sampling period, thereby increasing the number of spaced quantization samples of the input signal.

The time interval offset is a function of the naturally asynchronous and varying time difference that exists between a trigger point on the repetitive input signal and the sampling clock in the digital oscilloscope. The time interval offset is measured by a delay timer that determines the exact relative time positions of successive sets of acquired input samples.

Typical digital signal processing methods entail processing the quantized samples representing an input signal after all the quantized samples have been acquired and stored in the waveform memory. For example, random equivalent time sampling entails reading the quantized samples of a periodic sampling period from the waveform memory in a particular sequence to reconstruct the waveform. Such processing methods may be characterized as post-acquisition processing that can require a relatively large waveform memory to accommodate the unprocessed quantized samples.

Moreover, processing methods such as random equivalent time sampling improve the digital representation of an input signal by increasing the number of spaced digital samples within a sampling period. Although they increase the horizontal resolution of the digital representation, such methods require additional post acquisition processing steps to increase vertical resolution. In addition, the repeated sampling used by such methods is ineffective with nonperiodic or single-shot input signals.

Summary of the Invention

An object of this invention is, therefore, to provide a real-time signal processor that is capable of providing increased vertical resolution of quantized samples representing an input signal.

Another object of this invention is to provide such a signal processor that is compatible with single-shot input signals.

The present invention is a real-time digital signal processor that is capable of providing increased vertical resolution of digital input signals, including single-shot input signals. Single-shot signals are non-repetitive signals resulting from, for example, switch closures, explosive events, word-specific triggers, and timed samples of an event. In a preferred embodiment, the digital signal processor is employed in a digital oscilloscope having an analog-to-digital converter that generates successive eight-bit parallel digital input words representing an input electrical signal during a sampling period.

The analog-to-digital converter delivers the digital input words to the signal processor. The signal processor selectively passes the digital input words to a waveform memory circuit or averages successive ones of the digital input words and delivers an averaged digital word to the waveform memory circuit, thereby processing the digital input words in real time. The averaged digital words and the digital input words delivered to the waveform memory circuit are referred to as "quantized samples." The quantized samples represent the voltage magnitude of the input signal at successive time intervals during the sampling period.

The digital oscilloscope includes a display screen on which a waveform representing the input signal is reconstructed. The waveform is formed by transferring the quantized samples stored in waveform memory circuit to a display controller via a data bus. The waveform typically includes about 500 display points or pixels that are positioned on the display screen in accordance with the values of 500 corresponding quantized samples.

A timebase sweep adjustment allows an operator to select a sampling period over which the digital oscilloscope samples and displays the input signal. A typical digital oscilloscope has sampling periods spanning a range from 10 nano-seconds to hundreds of seconds. The sampling period establishes a decimation ratio N, which is the number of digital input words to be averaged by the signal processor for each pixel in the reconstructed waveform. The decimation ratio N increases for increasing sampling periods, i.e., longer sampling periods allow more individual signal samples to be averaged for each point displayed. No digital words are averaged for sampling periods of less than a preselected threshold, which is about 8 nanoseconds when the analog-to-digital converter operates at 250 MHz.

Averaging digital input words increases the number of bits in (i.e., the vertical resolution of) the resulting quantized sample. For example, the average of a pair of digital input words having integer resolution and values of 5 and 6 is 5.5. The vertical resolution of the average value is 0.5, which is twice the integer resolution of the digital input words.

Furthermore, the degree of averaging is a direct function of the decimation ratio N which is set by the timebase sweep selection. In this manner, the sweep selection provides a way of dynamically adjusting the vertical resolution of the digital oscilloscope.

The real-time averaging of the digital input words allows large numbers of them to be processed without previously being stored. As a result, the waveform memory circuit can have a relatively small data capacity of about 8 kilobits for storing 16-bit quantized samples representing 500 pixels in the reconstructed waveform. Since each 16-bit quantized sample can represent the average of N-number of data input words, the waveform memory circuit can store data representing very large numbers of processed input samples (e.g., $10^9$). Moreover, the real-time signal processing allows the digital oscilloscope to average the digital input words corresponding to single-shot signals and has the additional advantage of improving the speed and accuracy of DC measurements and calibration.

Additional objects and advantages of the present invention will be apparent from the following detailed description of preferred embodiments thereof, which proceeds with reference to the following drawings.

Brief Description of the Drawings

Fig. 1 is a simplified block diagram of a digital oscilloscope employing a signal processor of the present invention.

Fig. 2 is a graph of an exemplary input signal waveform and corresponding digital samples quantized at different vertical resolutions.

Fig. 3 is a block diagram of a signal processor and timebase controller of the present invention.

Fig. 4 is a timing diagram of signals controlling the signal processor of Fig. 3.

Fig. 5 is a block diagram of an alternative embodiment of the signal processor of the present invention.

Detailed Description of Preferred Embodiments

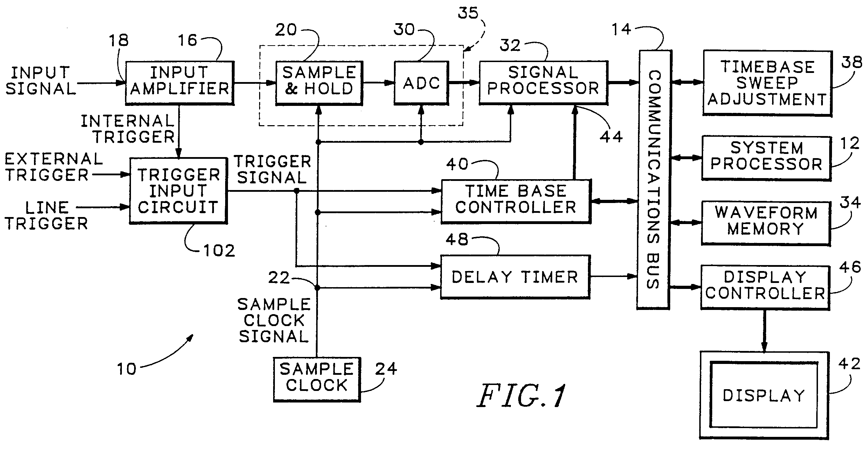

Fig. 1 is a simplified block diagram of a digital oscilloscope 10 controlled by a system processor 12 that communicates with various system components via a communication bus 14.

A variable gain input amplifier 16 receives an input voltage signal at an input 18 and amplifies the signal to have a maximum voltage magnitude within a predetermined voltage range. A sample-and-hold circuit 20 receives the signal from input amplifier 16 and acquires instantaneous voltage magnitudes or samples of the input signal. sample-and-hold circuit 20 acquires samples at a frequency of about 250 MHz in accordance with a 250 MHz fixed-frequency sample clock signal 22 delivered by a sample clock 24.

An analog-to-digital converter 30 receives the voltage samples and generates for each of them an eight-bit digital input word corresponding to the voltage magnitude of the input signal. Analog-to-digital converter 30 delivers the digital input words to a digital signal processor 32 that selectively passes the digital input words to a waveform memory circuit 34, or averages successive ones of the digital input words and delivers an averaged digital word to waveform memory circuit 34. Sample-and-hold circuit 20, analog-to-digital converter 30, and signal processor 32 receive and operate at the frequency of the clock signal; and signal processor 32 processes the digital input words in real time.

The averaged digital words and the digital input words delivered to waveform memory circuit 34 are referred to as "quantized samples." The quantized samples represent the instantaneous voltage magnitudes of the input signal at successive time intervals during a sampling period. The averaged digital words are generated whenever digital oscilloscope 10 is operated in a high-resolution mode selectable by the operator and the sampling period is greater than a predetermined minimum period. For a sampling frequency of 250 MHz, the predetermined minimum period is about 8 nanoseconds.

Sample-and-hold circuit 20 and analog-to-digital converter 30 function as a data acquisition circuit 35. Digital oscilloscope 10 preferably includes four similar data acquisition circuits 35 that receive the input signal from input amplifier 16. Each data acquisition circuit operates at a frequency of 250 MHz and samples the input signal in a quadrature interleaved manner, thereby providing an overall sampling frequency of 1 GHz. For purposes of clarity, however, only one data acquisition circuit 35 is shown.

A timebase sweep adjustment 38 allows an operator to select the sampling period over which digital oscilloscope 10 acquires samples and displays the input signal. Sweep adjustment 38 directs the selected sampling period over communication bus 14 to system processor 12, which delivers a corresponding sampling period control signal to a timebase controller 40. Sweep adjustment 38 typically refers to the time represented by each time division on an oscilloscope display screen 42, and display screen 42 includes ten time divisions. The sampling period is represented, therefore, by the product of the ten time divisions and the time per division sweep time established by sweep adjustment. Timebase controller 40 delivers timing control signals to inputs 44 of signal processor 32 for controlling the number of successive digital words to be averaged in accordance with the sampling period control signal.

A waveform representing the input signal is reconstructed or formed on display screen 42. The waveform is formed by transferring the quantized samples stored in waveform memory circuit 34 to a display controller 46 via communication bus 14. The waveform typically includes about 500 display points or pixels that are positioned on display screen 42 in accordance with the values of 500 corresponding quantized samples.

The averaging of digital input words by signal processor 32 allows digital oscilloscope 10 to employ all the input samples received by analog-to-digital converter 30 during a sampling period without having to store each digital input word at a separate location in waveform memory circuit 34. As a result, waveform memory circuit 34 requires a relatively small data capacity of about 8 kilobits for storing quantized samples representing up to about $5 \times 10^9$ digital input words, as described below in greater detail. Moreover, the real-time averaging provided by signal processor 32 allows digital oscilloscope 10 to average the digital input words corresponding to single-shot input signals.

The averaging of successive digital words provides increased vertical resolution of the quantized samples. Table 1 shows binary representations and running sums or accumulated values of four exemplary samples. (Decimal representations of the samples are included for purposes of clarity.) The overall sum of the four samples is 21 (i.e., 10101), and the average is 5.25 (i.e., 101.01). It will be appreciated that the average of $2^N$ number of binary values may be computed by summing the values and then shifting the decimal point N-number of bits to the left.

4

TABLE I

| Decimal | | Binary | |
|---|---|---|---|
| Sample | Sum | Sample | Sum |
| 4V | 4 | 100 | 100 |
| 5V | 9 | 101 | 1001 |
| 6V | 15 | 110 | 1111 |
| 6V | 21 | 110 | 10101 |
| Average = 5.25 | | Average = 101.01 | |

The average of the four three-bit samples is represented by a five-bit result, which has a vertical resolution four times greater than that of the three-bit samples. In particular, the samples have a resolution of 1, whereas the average has a resolution of 0.25. Similarly, the average of 256 (i.e., $2^8$) samples would be represented by a result having 8 more bits than the sample, thereby providing a vertical resolution that is 256 times greater than that of the samples. As a result, signal processor 32 is capable of achieving 16-bit resolution from 8-bit input samples by averaging at least 256 eight-bit digital input words.

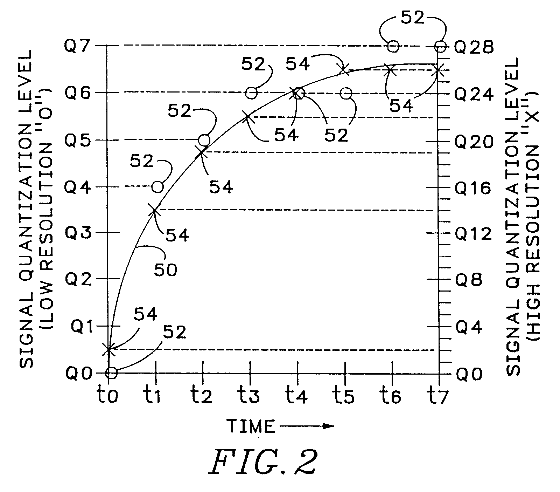

Fig. 2 shows by example the benefit derived from increasing the vertical resolution of signal quantizing. Input signal waveform 50 represents an input signal, and digital samples 52 and 54 represent different vertical resolutions at which waveform 50 can be sampled and stored in waveform memory.

Low-resolution digital samples 52 are represented as circles and have quantization levels as indicated on the left-side vertical axis. Such low-resolution quantization levels might represent the quantization level of an analog-to-digital converter.

High-resolution digital samples 54 are represented as crosses and have four times higher vertical resolution as indicated on the right-side vertical axis. Such higher-resolution quantization levels can result from signal averaging such as that provided by the present invention. Fig. 2 shows that the averaging of digital input words can improve the vertical resolution with which quantized samples represent an input signal. The higher resolution samples 54 more closely fit the actual values of the input signal waveform 50 than do the low-resolution samples 52. Improved vertical resolution has particular value when display controller 46 and display 42 have high resolution display capability.

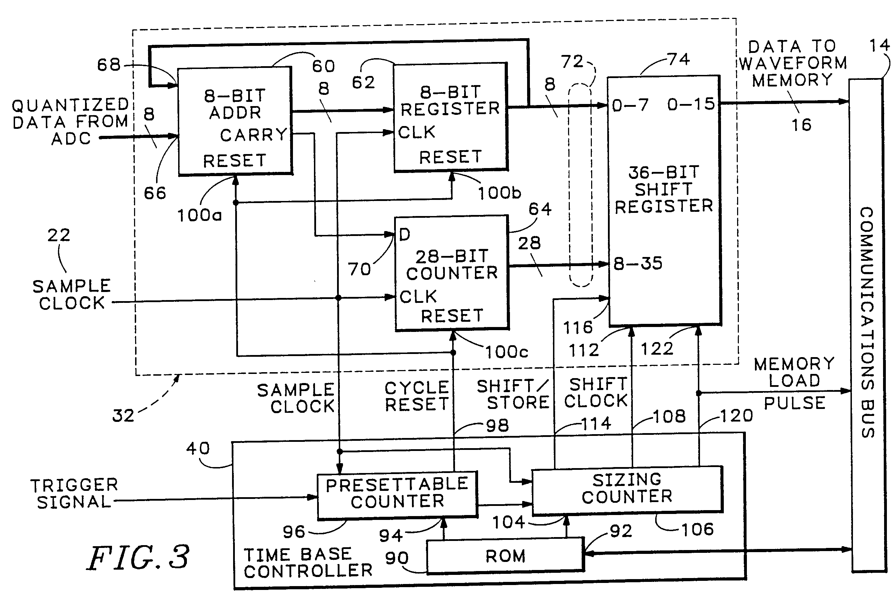

Fig. 3 is a block diagram of signal processor 32 and timebase controller 40 shown in Fig. 1. Signal processor 32 includes an 8-bit adder 60, an 8-bit register 62, and a 28-bit counter 64 that cooperate to accumulate or sum successive digital words generated by analog-to-digital converter 30. The 8-bit capacity of adder 60 and register 62 matches that of analog-to-digital converter 30.

In operation, adder 60 sums a pair of 8-bit digital words received at a pair of inputs 66 and 68. Input 66 receives one of the successive digital words directly from analog-to-digital converter 30 during an accumulation period. Input 68 receives from register 62 an 8-bit digital word representing the eight least significant bits ("LSB") of the accumulated value of the prior digital words received from analog-to-digital converter 30 during the accumulation period. 8-bit register 62 loads data from adder 60 while sample clock signal 22 is in a high logic state and transfers the previously loaded data to adder 60 input 68 when sample clock signal 22 changes to a low logic state thereby creating a one sample clock pulse delay of adder data through 8-bit register 62. It is the delay of the adder data that causes the accumulation of successive digital words.

Whenever the sum generated by adder 60 exceeds eight bits, adder 60 delivers a carry pulse to an input 70 of counter 64. Register 62 and counter 64 deliver to inputs 72 of a 36-bit shift register 74 a 36-bit accumulated value representing the sum of all digital input words received during the accumulation period. At the end of the accumulation cycle, shift register 74 divides the accumulated value by the number of accumulated digital input words incorporated into it to determine the average, as described below in greater detail. The 36-bit capacity of shift register 74 matches the sum of the capacities of register 62 and counter 64.

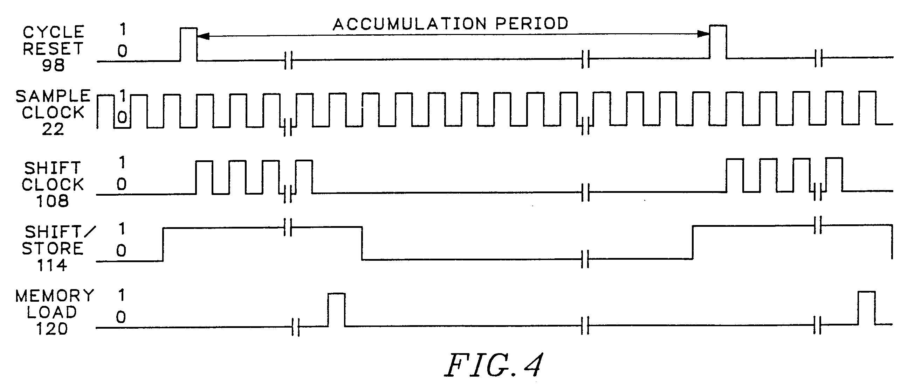

Timebase controller 40 coordinates the operation of signal processor 32 using control signals of the type shown in Fig. 4. With reference to Figs. 3 and 4, a read only memory ("ROM") circuit 90 receives a timebase control signal at an input 92. The timebase control signal represents an accumulation period over which digital input words are acquired for each quantized sample. The timebase control signal is delivered via processor 12 and communication bus 14.

ROM circuit 90 delivers a preset value or decimation ratio N to an input 94 of a presettable counter 96. The decimation ratio N represents the number of digital input words to be averaged for each quantized

EP 0 507 470 A2

value. The accumulation of the digital input words for a quantized sample is initialized by a cycle reset pulse 98 delivered by presettable counter 96 to reset inputs 100a, 100b, and 100c of adder 60, register 62, and counter 64, respectively. Cycle reset signal 98 can be generated in response to a trigger signal received from a trigger input circuit 102 (Fig. 1), which is capable of employing internal, external, or line triggers. Generally, however, cycle reset signal 98 is timed to allow the acquisition of a predetermined number of signal samples occurring either before or after the trigger signal in accordance with conventional storage oscilloscope practice.

Register 62, counter 64, and presettable counter 96 receive and operate at the frequency of sample clock signal 22. Presettable counter 96 counts the digital input words being accumulated during the accumulation period.

ROM circuit 90 also delivers a shift factor signal P to an input 104 of a sizing counter 106. The shift factor signal controls the number of bits by which the accumulated value of the digital input words is shifted to the right (i.e., the decimal point is shifted to the left) to divide the accumulated value.

Sizing counter 106 generates a shift clock signal 108 which is delivered to input 112 of shift register 74. Sizing counter 106 also applies a shift/store signal 114 in a high logic state to input 116 of shift register 74. The high logic state of shift/store signal 114 is initiated when sizing counter 106 detects the end of an accumulation period as set by presettable counter 96. Shift register 74 alternately stores or blocks the accumulated values on inputs 72 whenever shift/store signal 114 is in the low and high logic states, respectively. The number P of clock pulses in shift clock signal 108 is determined from the number N of digital input words incorporated into the accumulated value, as described below in greater detail.

After the decimal point in the accumulated value is shifted, sizing counter 106 delivers a memory load pulse 120 to input 122 of shift register 74 and communication bus 14 for delivery to waveform memory 34. In response to memory load pulse 120, shift register 74 transfers the decimal-shifted accumulated value to waveform memory 34 via communication bus 14.

With reference to Fig. 4, sample clock signal 22 is the master timing signal for digital signal processor 32, data acquisition circuit 35, and timebase controller 40. Presettable counter 96 determines the accumulation period of signal processor 32 by counting N sample clock signal 22 pulses and generating cycle reset pulse 98. Register 62 and counter 64 are reset by cycle reset pulse 98, starting the accumulation of the sum of the digital input words received from analog-to-digital converter 30 during the ensuing accumulation period.

During accumulation of the sum, shift register 74 is held in a store mode by shift/store signal 114, thereby causing shift register 74 to store the accumulating sum during the accumulation period. Shift register 74 is changed to the shift mode by shift/store signal 114 just before next cycle reset pulse 98, thereby storing the final accumulated sum at the end of the accumulation period. Cycle reset pulse 98 starts a new accumulation period. Shift/store signal 114 remains in a high logic state, while shift register 74 is shifted right P times by shift clock 108 causing binary division of the accumulated sum and thereby generating the average of N quantized signal samples. The resulting average is sent to communications bus 14 by memory load pulse 120 immediately following the final cycle of shift clock pulse 108. Lastly, shift/store signal 114 changes to a low logic state, returning shift register 74 to the store mode again enabling storage of the sum being accumulated during the new accumulation period.

The binary division described above is applicable to the averaging of $2^N$ number of digital input words. The sampling periods employed in digital oscilloscope 10 are not, however, incremented in powers of 2. In particular, oscilloscope operators prefer decimal increments of 1, 2 or 2.5, 5, and 10. As a consequence, the number P of pulses in shift clock signal 108 provides only an approximate average of the accumulated value, thereby requiring a scale factor K to provide an accurate quantized value. The approximate average is multiplied by the scale factor K to provide an accurate average of the accumulated digital words. The multiplication is preferably performed by system processor 12 when the approximate average is transferred from shift register 74 toward waveform memory 34.

The number P of pulses in shift pulse signal 108 is determined by the following "floor function" equation. A floor function generates the greatest integer that is lower than the calculated quantity:

$$\text{Shift factor 'P'} = \text{Floor} \left\lfloor \log(2) \frac{N*256}{65536} \right\rfloor$$

6

Where N, the decimation ratio, represents the number of accumulated digital input words, the factor 256 represents the maximum value that can be accumulated by register 62, and the factor 65536 represents the maximum accumulated value that can be presented in sixteen bits to inputs 72 of shift register 74. A shift of the decimal place of the accumulated value by P number of bits (binary division) averages the accumulated value over the N number of accumulated digital words, and scales the average to obtain the sixteen most significant bits (MSB) of the accumulated value in shift register 74.

Scale factor K is determined by the equation:

$$\text{Scale factor 'K'} = \frac{65536}{N*256*2^{P}}$$

Table 2 lists the shift factors P, scale factors K, and decimation ratios N associated with each of thirty timebase sweep adjustments 38 selectable by an operator of digital oscilloscope 10. The shift factor P, scale factor K, and decimation value N associated with each sampling period are identified by an index value I that is delivered to ROM 90 input 92 by system processor 12. In response to a particular index value I, ROM circuit 90 delivers the corresponding decimation value N and shift factor P to presettable counter 94 and sizing counter 106, respectively. In the preferred embodiment, scale factor K is known by system processor 12 as a function of timebase sweep adjustment 38. It should be recognized that ROM 90 can be readily replaced by any of a variety of memory circuits or registers that are loadable by processor 12.

TABLE 2

| Index I | Decimation Ratio N | Shift Factor P | Scale Factor K |
|---|---|---|---|
| 0 | 1 | 0 | 256.00 |
| 1 | 2 | 0 | 128.00 |
| 2 | 5 | 0 | 51.20 |
| 3 | 10 | 0 | 25.60 |
| 4 | 25 | 0 | 10.24 |
| 5 | 50 | 0 | 5.12 |
| 6 | 100 | 0 | 2.56 |
| 7 | 250 | 0 | 1.02 |
| 8 | 500 | 1 | 1.02 |
| 9 | $1 \times 10^3$ | 2 | 1.02 |
| 10 | $2.5 \times 10^3$ | 4 | 1.64 |
| 11 | $5 \times 10^3$ | 5 | 1.64 |
| 12 | $10 \times 10^3$ | 6 | 1.64 |
| 13 | $25 \times 10^3$ | 7 | 1.31 |
| 14 | $50 \times 10^3$ | 8 | 1.31 |
| 15 | $1 \times 10^5$ | 9 | 1.31 |
| 16 | $2.5 \times 10^5$ | 10 | 1.05 |
| 17 | $5 \times 10^5$ | 11 | 1.05 |
| 18 | $10 \times 10^5$ | 12 | 1.05 |
| 19 | $25 \times 10^5$ | 14 | 1.68 |
| 20 | $50 \times 10^5$ | 15 | 1.68 |
| 21 | $1 \times 10^7$ | 16 | 1.68 |
| 22 | $2.5 \times 10^7$ | 17 | 1.34 |
| 23 | $5 \times 10^7$ | 18 | 1.34 |
| 24 | $10 \times 10^7$ | 19 | 1.34 |
| 25 | $25 \times 10^7$ | 20 | 1.07 |
| 26 | $50 \times 10^7$ | 21 | 1.07 |
| 27 | $1 \times 10^9$ | 22 | 1.07 |
| 28 | $2.5 \times 10^9$ | 24 | 1.72 |
| 29 | $5 \times 10^9$ | 25 | 1.72 |

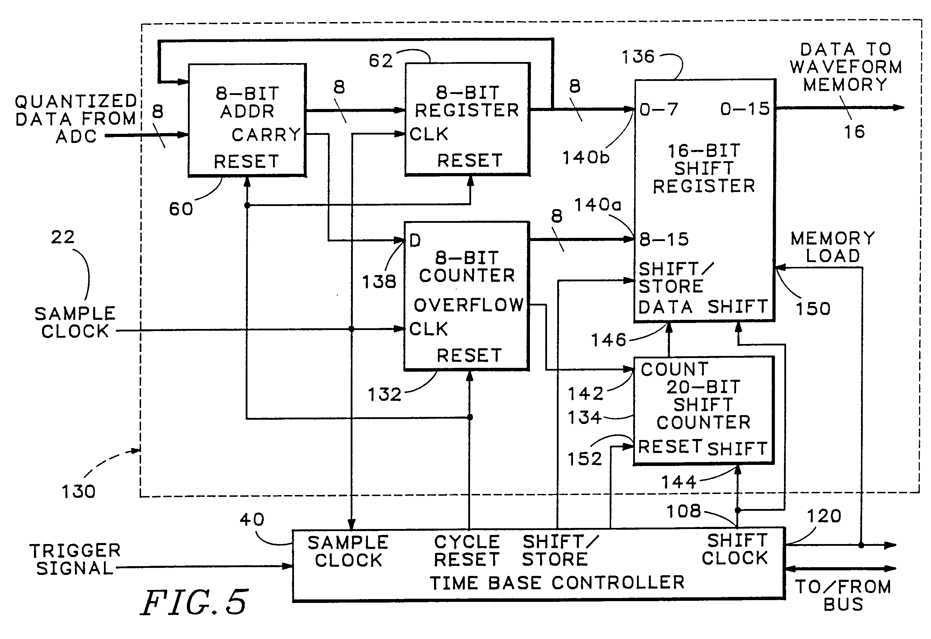

Fig. 5 is a block diagram of an alternative signal processor 130 of the present invention. Signal processor 130 is similar to signal processor 32 of Fig. 1, except that signal processor 130 includes an 8-bit counter 132, a 20-bit shift counter 134, and a 16-bit shift register 136 as substitutes for counter 64 and a portion of shift register 74.

Signal processor 130 is desirable because shift counter 134 alternatively performs counting functions and shifting functions, thereby reducing the circuitry dedicated to counter 64 and register 74 of signal processor 32. Since each of processors 32 and 130 is preferably formed as a portion of a monolithic CMOS circuit, reduced circuitry simplifies the manufacture of the signal processors. In the alternative preferred embodiment, time base controller 40 forms the remaining portion of the same monolithic CMOS circuit.

Counter 132 and shift counter 134 cooperate to function as a 28-bit counter in a manner similar to counter 64. In operation, counter 132 includes an input 138 that receives carry pulses from adder circuit 60. Counter 132 counts the carry pulses and delivers an 8-bit value representing them to inputs 140a of register 136. Counter 132 delivers an overflow pulse to a count input 142 of shift counter 134 whenever the count exceeds a full 8-bit value. Shift counter 134 is configured to count up to a 20-bit number of overflow pulses. Register 62 delivers an 8-bit value representing the least significant bits ("LSB") of the accumulated value to inputs 140b.

In addition to counting overflow pulses from counter 132, shift counter 134 also performs shifting functions in cooperation with shift register 136 to compute an average of the accumulated digital input words. The counting and shifting functions of shift counter 134 are controlled by time base controller 40. Shift counter 134 operates in a shifting mode whenever an input 144 receives clock shift pulses 108, and operates in a counting mode otherwise.

In the shifting mode, shift counter 134 delivers to a data input 146 of shift register 136 a number of bits equal to the number of clock shift pulses. The bits delivered to shift register 136 by shift counter 134 represent the most significant bits ("MSB") of the accumulated value of the digital input words. As a result, the MSB bits displace an equal number of least significant bits ("LSB") received at inputs 140a and 140b of shift register 136. The resulting 16-bit average value is then transferred to waveform memory circuit 34 in response to memory load pulse 120 received at a memory load input 150 of shift register 136.

At the end of the shift mode, timebase controller 40 delivers a reset signal to a reset input 152 of shift counter 134. In response to the reset signal, the values in shift counter 134 are cleared so shift counter 134 can begin the counting mode for a new accumulated value. The capacity of counter 132 is selected, therefore, so that it can accumulate carry signals from adder 60 without generating an overflow pulse while shift counter 134 operates in the shift mode. 8-bit capacity is employed so that counter 132, shift counter 134, and shift register 136 can each receive an even number of bits.

The number of bits ("size") required by various circuits in signal processor 32 or alternate signal processor 130 may be varied depending on differing application requirements. If the size of quantized data from ADC 30 is other than 8-bits, then adder 60 and register 62 should match the ADC size. The size of counter 64 is a function of decimation ratio N and requires a minimum of $\log_2 N$ bits. The same size requirement applies to the counter formed by the combination of counter 132 and shift/counter 134 of alternate signal processor 130. The size of shift register 74 is, at a minimum, the size of register 62 plus the size of counter 64. In alternate signal processor 130, the size of shift register 136 should at least match the size requirements of the maximum vertical resolution, which in this example is 16 bits.

In applications where decimation ratio N can be restricted to powers of 2 and shift factor 'P' to greater than zero, scale factor 'K' can be dropped from consideration since the resulting division will be in even binary values, thereby eliminating scale factor 'K' variances.

It will be obvious to those having skill in the art that many changes may be made to the details of the above-described embodiments of this invention without departing from the underlying principles thereof. The scope of the present invention should be determined, therefore, only by the following claims.

**Claims**

1. A signal processor for a digital oscilloscope, comprising:

signal acquisition means for acquiring plural samples of an input electrical signal and for quantizing each sample as a corresponding digital signal;

real-time averaging means receiving the digital signals for computing an average of a predetermined number of the digital signals;

memory means in data communication with the real-time averaging means for receiving and storing the average; and

display means in data communication with the memory means for retrieving the digital signals therefrom and forming in accordance with them a display image representing the input electrical signal.

2. The signal processor of claim 1 in which the electrical signal is a single-shot electrical signal.

3. The signal processor of claim 1 in which each digital signal represents a value and the real-time averaging means includes accumulating means for computing a sum of the values of the predetermined number of digital signals and dividing means for dividing the sum by the predetermined number, thereby to compute the average.

4. The signal processor of claim 3 in which the accumulating means includes:
   a register circuit that stores the sum of the digital signals; and
   an adder circuit that receives the digital signals and the sum stored in the register circuit, adds the sum and the digital signal to form a new sum, and delivers the new sum to the register circuit for storage.

5. The signal processor of claim 3 in which the dividing means includes a shift register that receives the sum and performs a shift operation to divide the sum by a number corresponding to the predetermined number of digital signals.

6. The signal processor of claim 5 in which the shift operation provides an approximate average of the digital signal values, and in which the dividing means further includes a data processor for correcting the approximate average.

7. The signal processor of claim 1 in which the real-time averaging means includes:
   accumulating means for computing a sum of the values of the predetermined number of digital signals, the accumulating means including a register circuit that stores the sum of the digital signals, and an adder circuit that receives the digital signals and the sum stored in the register circuit, adds the sum and the digital signal to form a new sum, and delivers the new sum to the register circuit for storage; and
   dividing means for dividing the sum by the predetermined number, the dividing means including a shift register that receives the sum and performs a shift operation to divide the sum by a number corresponding to the predetermined number of digital signals.

8. The signal processor of claim 7 in which the shift operation provides an approximate average of the digital signal values, and in which the dividing means further includes a data processor for correcting the approximate average.

9. A digital signal processor, comprising:
   signal acquisition means for acquiring plural samples of an input electrical signal and for quantizing each sample as a corresponding digital signal;
   real-time averaging means receiving the digital signals for computing an average of a predetermined number of them; and
   memory means in data communication with the real-time averaging means for receiving and storing the average.

10. The signal processor of claim 9 in which the electrical signal is a single-shot electrical signal.

11. The signal processor of claim 9 in which each digital signal represents a value and the real-time averaging means includes accumulating means for computing a sum of the values of the predetermined number of digital signals and dividing means for dividing the sum by the predetermined number, thereby to compute the average.

12. The signal processor of claim 11 in which the accumulating means includes a register circuit that stores the sum of the digital signals, and an adder circuit that receives the digital signals and the sum stored in the register circuit, adds the sum and the digital signal to form a new sum, and delivers the new sum to the register circuit for storage.

13. The signal processor of claim 11 in which the dividing means includes a shift register that receives the sum and performs a shift operation to divide the sum by a number corresponding to the predetermined number of digital signals.

14. The signal processor of claim 13 in which the shift operation provides an approximate average of the digital signal values and the dividing means further includes a data processor for correcting the approximate average.

15. The signal processor of claim 9 in which the real-time averaging means includes:

accumulating means for computing a sum of the values of the predetermined number of digital signals, the accumulating means including a register circuit that stores the sum of the digital signals; and an adder circuit that receives the digital signals and the sum stored in the register circuit, adds the sum and the digital signal to form a new sum, and delivers the new sum to the register circuit for storage; and

dividing means for dividing the sum by the predetermined number, the dividing means including a shift register that receives the sum and performs a shift operation to divide the sum by a number corresponding to the predetermined number of digital signals.

16. The signal processor of claim 15 in which the shift operation provides an approximate average of the digital signal values and the dividing means further includes a data processor for correcting the approximate average.

17. A signal processing method comprising the steps of:

quantizing plural samples of an electrical signal into corresponding plural N-bit digital signals;

receiving the plural N-bit digital signals and generating a greater-than-N-bit digital real-time average of a predetermined number of the N-bit digital signals;

storing the greater-than-N-bit digital real-time averages in a memory;

displaying the contents of the memory in a form representing the electrical signal; and

controlling the predetermined number of the N-bit digital signals used to generate the greater-than-N-bit digital average for changing an amount of time over which the electrical signal is averaged.

18. The method of claim 17 in which the controlling step uses a memory to determine the predetermined number of N-bit digital signals used to generate the greater-than-N-bit digital average.

19. The method of claim 17 further comprising a step of correcting the greater-than-N-bit digital real-time average with a scale factor when controlling the predetermined number of N-bit digital signals used to generate the greater-than-N-bit digital average.

20. The method of claim 17 in which the electrical signal is a single-shot electrical signal.

21. A signal processing method of a digital oscilloscope, comprising the steps of:

quantizing a predetermined number of samples of an electrical signal into a corresponding number of N-bit digital signal values;

accumulating in real-time a greater-than-N-bit sum of the N-bit digital signal values quantized during an accumulation period;

dividing the greater-than-N-bit sum by the predetermined number at the end of each accumulation period to generate an average value of the corresponding number of N-bit digital signal values; and

controlling the accumulation period as a function of the predetermined number for changing an amount of time over which the electrical signal is averaged.

22. The method of claim 21 further comprising a step of multiplying the average value by a scale factor when the predetermined number is changed.

23. The method of claim 21 in which the electrical signal is a single-shot electrical signal.

*FIG. 1*

FIG. 2

FIG. 3

COMMUNICATIONS BUS — 14

DATA TO WAVEFORM MEMORY — 16

MEMORY LOAD PULSE — 120

36-BIT SHIFT REGISTER — 74 (0-7, 0-15, 8-35)

72

SIZING COUNTER — 106, 92

SHIFT CLOCK — 108, 114
122, 116, 112

8 — 72

8-BIT REGISTER CLK RESET — 62, 60, 100b

28-BIT COUNTER D CLK RESET — 64, 28, 70, 100c

SHIFT/STORE — 98

ROM — 104, 90

PRESETTABLE COUNTER — 94, 96

CYCLE RESET

SAMPLE CLOCK

8-BIT ADDR CARRY RESET — 66, 100a

68

8 — QUANTIZED DATA FROM ADC

22 SAMPLE CLOCK

32

40 TIME BASE CONTROLLER

TRIGGER SIGNAL

13

*FIG.4*

EP 0 507 470 A2

QUANTIZED DATA FROM ADC — 8

8-BIT ADDR / CARRY / RESET — 60

8-BIT REGISTER / CLK / RESET — 62

8-BIT COUNTER / D / OVERFLOW / CLK / RESET — 138, 132

DATA TO WAVEFORM MEMORY — 16

16-BIT SHIFT REGISTER / 0-15 / 0-7 / 8-15 / SHIFT/STORE / DATA SHIFT — 136, 140b, 140a, 146

20-BIT SHIFT COUNTER / COUNT / RESET SHIFT — 142, 134, 152, 144

MEMORY LOAD — 150

SHIFT CLOCK — 108

TO/FROM BUS — 120

TIME BASE CONTROLLER / CYCLE SHIFT/RESET STORE / SAMPLE CLOCK — 40

SAMPLE CLOCK — 22

TRIGGER SIGNAL

130

*FIG.5*

15